# EUROPEAN PATENT APPLICATION

(11) **EP 4 818 719 A1**
(43) Date of publication of application: **07.10.2026**
(21) Application number: 24895693.0
(22) Date of filing: 29.07.2024
(51) Int. Cl.: G01R 31/385, G01R 15/04, G01R 1/04, H01M 10/42, H01M 10/48

(54) **SIGNAL SAMPLING CIRCUIT, BATTERY MANAGEMENT SYSTEM, BATTERY SYSTEM AND ELECTRICAL APPARATUS**

(30) Priority: 30.11.2023 CN 202323264267 U
(71) Applicant: Contemporary Amperex Technology Co., Limited, Ningde, Fujian 352100 (CN)
(72) Inventor: GUO, Maobo, Ningde, Fujian 352100 (CN); WANG, Xingchang, Ningde, Fujian 352100 (CN); LIU, Jingjiang, Ningde, Fujian 352100 (CN); LI, Qiandeng, Ningde, Fujian 352100 (CN); YE, Fuming, Ningde, Fujian 352100 (CN)
(74) Representative: Lorenz Seidler Gossel Part. mbB
(86) International application number: PCT/CN2024/108062
(87) International publication number: WO 2025/112590

(57) **Abstract**

A signal sampling circuit, a battery management system, a battery system and an electrical apparatus. The signal sampling circuit (10) comprises a first voltage divider module (11), a first switch module (12) and a sampling module (13), wherein the first voltage divider module (11) and the first switch module (12) are connected in series between a point to be tested and a reference signal terminal of the sampling module (13), a first control terminal of the first switch module (12) is connected to a first power supply terminal, a second control terminal of the first switch module (12) is connected to an enable signal terminal of the sampling module (13), the sampling module (13) is connected to a first reference ground, the first voltage divider module (11) is internally provided with a sampling point, and the sampling module (13) is used for collecting a sampling signal at the sampling point. The present application helps to reduce the cost of signal sampling circuits.

## Description

### CROSS-REFERENCE TO RELATED APPLICATION

The present application claims priority to Chinese Patent Application No. 202323264267.5, filed on November 30, 2023 and entitled "SIGNAL SAMPLING CIRCUIT, BATTERY MANAGEMENT SYSTEM, BATTERY SYSTEM, AND ELECTRIC DEVICE", the content of which is incorporated herein by reference in its entirety.

### TECHNICAL FIELD

The present application relates to the technical field of batteries, and in particular, to a signal sampling circuit, a battery management system, a battery system, and an electric device.

### BACKGROUND

With the continuous development of battery technology, people have higher and higher requirements for batteries.

In the related art, a signal sampling circuit is provided to perform sampling on a point to be detected. However, the signal sampling circuit in the related art has a problem of high cost.

### SUMMARY

The present application provides a signal sampling circuit, a battery management system, a battery system, and an electric device, which help to reduce the cost of the signal sampling circuit.

According to a first aspect, the present application provides a signal sampling circuit. The signal sampling circuit includes a first voltage divider module, a first switch module, and a sampling module.

The first voltage divider module and the first switch module are connected in series between a point to be detected and a reference signal terminal of the sampling module, a first control terminal of the first switch module is connected to a first power supply terminal, a second control terminal of the first switch module is connected to an enabling signal terminal of the sampling module, and the sampling module is connected to a first reference ground.

The first voltage divider module is provided therein with a sampling point, and the sampling module is configured to collect a sampled signal of the sampling point.

In embodiments of the present application, the first control terminal of the first switch module is connected to the first power supply terminal. When the point to be detected is a high-voltage point to be detected, the first power supply terminal may be a high-voltage power supply terminal, and the first reference ground may be a high-voltage ground. The first control terminal of the first switch module is connected to the first power supply terminal, the second control terminal of the first switch module is connected to the enabling signal terminal of the sampling module, and the sampling module is connected to the high-voltage ground. Therefore, the sampling module is on a high voltage side, such that both the control terminal and the controlled terminal of the first switch module are on the high voltage side. Therefore, compared with using a high insulation withstand voltage device, the control terminal and the controlled terminal of the first switch module help reduce costs of the signal sampling circuit.

In an optional implementation of the first aspect, the signal sampling circuit further includes a second switch module, the second switch module is connected between the second control terminal of the first switch module and the first reference ground, a control terminal of the second switch module is connected to the enabling signal terminal, and the second switch module is configured to be turned on or turned off under control of the control signal provided by the enabling signal terminal and further control the first switch module to be turned on or turned off. In this way, when the control signal provided by the enabling signal terminal cannot drive the first switch module to be turned on or turned off, the control signal provided by the enabling signal terminal may be used to drive the second switch module to be turned on or turned off, and further control the first switch module to be turned on or turned off, thereby improving the driving capability of the signal sampling circuit.

In an optional implementation of the first aspect, the signal sampling circuit further includes a second voltage divider module, and the second voltage divider module is connected between the first power supply terminal and the enabling signal terminal. In this way, by providing the second voltage divider module between the first power supply terminal and the enabling signal terminal, the voltages on the first control terminal and the second control terminal of the first switch module can be reduced, thereby protecting the first switch module.

In an optional implementation of the first aspect, the first voltage divider module includes a voltage divider submodule, and the voltage divider submodule may be provided therein with a sampling point. The first switch module includes a relay, and the relay includes a coil and a contact group. The voltage divider submodule and the contact group are connected in series between the point to be detected and the reference signal terminal of the sampling module, a first terminal of the coil is connected to the first power supply terminal, and a second terminal of the coil is connected to the enabling signal terminal. In this way, by using the voltage divider submodule with the contact group of the relay to divide the voltage, the voltage of the contact group of the relay is reduced, thereby protecting the relay. In addition, the voltage of the second terminal of the coil of the relay is controlled by the enabling signal terminal, and then the contact group of the relay can be controlled to be turned on, and thus the sampling module can collect the sampled signal of the sampling point.

In an optional implementation of the first aspect, the first voltage divider module includes N voltage divider submodules, and each voltage divider submodule may be provided therein with a sampling point, where N is an integer greater than or equal to 2. The first switch module includes a relay, and the relay includes a coil and N contact groups. The voltage divider submodules and the contact groups are connected in series in one-to-one correspondence to form N branches, one terminal of each of the N branches is connected to the corresponding point to be detected of the N points to be detected, and the other terminal of each of the N branches is connected to the reference signal terminal. A first terminal of the coil is connected to the first power supply terminal, and a second terminal of the coil is connected to the enabling signal terminal. In this way, by using the N voltage divider submodules with the N contact groups of the relay to divide the voltages in one-to-one correspondence, the voltages of the N contact groups of the relay are reduced, thereby protecting the relay. In addition, the voltage divider submodules and the contact groups are connected in series in one-to-one correspondence to form the N branches, and one terminal of each of the N branches is connected to the corresponding point to be detected of the N points to be detected. Further, the enabling signal terminal controls the voltage of the second terminal of the coil, such that the N contact groups can be controlled to be simultaneously turned on or turned off, and thus the sampling module can simultaneously collect sampled signals of N sampling points that are in one-to-one correspondence to the N points to be detected.

In an optional implementation of the first aspect, the second switch module includes a transistor. In this way, by providing the transistor in the second switch module, when the control signal provided by the enabling signal terminal cannot drive the first switch module to be turned on or turned off, the control signal provided by the enabling signal terminal may be used to drive the transistor to be turned on or turned off, and further control the first switch module to be turned on or turned off, thereby improving the driving capability of the signal sampling circuit.

In an optional implementation of the first aspect, the transistor includes a triode or an MOS transistor. In this way, by providing the triode or the MOS transistor in the second switch module, when the control signal provided by the enabling signal terminal cannot drive the first switch module to be turned on or turned off, the control signal provided by the enabling signal terminal may be used to drive the triode or the MOS transistor to be turned on or turned off, and further control the first switch module to be turned on or turned off, thereby improving the driving capability of the signal sampling circuit.

In an optional implementation of the first aspect, the voltage divider submodule includes a first resistor and a second resistor. The first resistor and the second resistor are connected in series, and the sampling point is arranged between the first resistor and the second resistor. In this way, by providing the first resistor and the second resistor in the voltage divider submodule, the voltage of one or N contact groups of the relay can be reduced, thereby protecting the relay. In addition, the voltage of the second resistor may be flexibly controlled by adjusting the quantity and resistance value of the first resistor.

In an optional implementation of the first aspect, the second voltage divider module includes a third resistor. In this way, by providing the third resistor in the second voltage divider module, the voltages on the first control terminal and the second control terminal of the first switch module can be reduced, thereby protecting the first switch module.

Based on the same inventive concept, according to a second aspect, the embodiments of the present application further provide a battery management system. The battery management system includes:
a controller;
an isolation communication module; and
the signal sampling circuit according to any embodiment of the first aspect. The sampling module in the signal sampling circuit is connected to the controller via the isolation communication module.

Based on the same inventive concept, according to a third aspect, the embodiments of the present application further provide a battery system including a battery and the battery management system according to the second aspect.

Based on the same inventive concept, according to a second aspect, the embodiments of the present application further provide an electric device. The electric device includes the battery management system according to the second aspect.

The above description is only an overview of the technical solutions of the present application. To more clearly understand the technical means of the present application to enable implementation in accordance with the content of the specification and to make the above and other purposes, features, and advantages of the present application more obvious and easy to understand, the detailed description of the present application is provided below.

### BRIEF DESCRIPTION OF THE DRAWINGS

Features, advantages, and technical effects of exemplary embodiments of the present application will be described below with reference to the drawings.
FIG. 1 is a schematic structural diagram of a signal sampling circuit according to an embodiment of the present application;
FIG. 2 is a schematic structural diagram of a signal sampling circuit according to another embodiment of the present application;
FIG. 3 is a schematic structural diagram of a signal sampling circuit according to yet another embodiment of the present application;
FIG. 4 is a schematic structural diagram of a signal sampling circuit according to yet another embodiment of the present application;
FIG. 5 is a schematic structural diagram of a signal sampling circuit according to yet another embodiment of the present application;
FIG. 6 is a schematic structural diagram of a signal sampling circuit according to yet another embodiment of the present application;
FIG. 7 is a schematic structural diagram of a battery management system according to an embodiment of the present application;
FIG. 8 is a schematic structural diagram of a battery system according to an embodiment of the present application; and
FIG. 9 is a schematic structural diagram of an electric device according to an embodiment of the present application.

### Description of reference numerals:

10, signal sampling circuit; 11, first voltage divider module; 111, voltage divider submodule; 12, first switch module; 13, sampling module; 14, second switch module; 15, second voltage divider module; 20, isolation communication module; 30, controller; 100, battery management system; 200, battery; 1000, battery system; 2000, electric device;
EN2: enabling signal terminal; S: sampling point; HV-GND: first reference ground; LV-GND: second reference ground; HV1: point to be detected; Vref: reference signal terminal; VDD: first power supply terminal; V1: first sampling terminal.

### DETAILED DESCRIPTION

To make the objectives, technical solutions, and advantages of embodiments of the present application clearer, the technical solutions in the embodiments of the present application will be clearly and comprehensively described hereinafter with reference to the drawings in the embodiments of the present application. It is obvious that the described embodiments are some, but not all, embodiments of the present application. Based on the embodiments in the present application, all other embodiments obtained by those of ordinary skill in the art without creative work shall fall within the protection scope of the present application.

Unless otherwise defined, all technical and scientific terms used in the present application have the same meaning as commonly understood by those skilled in the art to which the present application belongs. The terms used in the specification of the present application are only used to describe specific embodiments and are not intended to limit the present application. The terms "include", "comprise", "provided with", and any variants thereof in the specification and claims of the present application and the above description of the drawings are intended to cover a non-exclusive inclusion. The terms "first", "second", and the like in the specification and claims of the present application and the above drawings are used to distinguish different objects and are not intended to describe a specific order or priority.

In the description of the present application, it should be noted that unless otherwise explicitly specified or limited, the terms "mount", "interconnect", "connect", and "attach" shall be construed broadly and may be, for example, fixed connection, detachable connection, or integrated connection, or direct connection, indirect connection via an intermediate, or a communication between interiors of two elements. For those of ordinary skill in the art, the specific meanings of the aforementioned terms in the present application can be understood according to specific conditions.

The signal sampling circuit in the related art needs to have a function of high insulation withstand voltage, but the electronic device with high insulation withstand voltage has high costs, which leads to the problem of high costs of the signal sampling circuit in the related art.

The embodiments of the present application provide a signal sampling circuit, a battery management system, a battery system, and an electric device. The signal sampling circuit according to the embodiments of the present application will be described in detail below with reference to the accompanying drawings.

The following first describes the signal sampling circuit according to the embodiments of the present application.

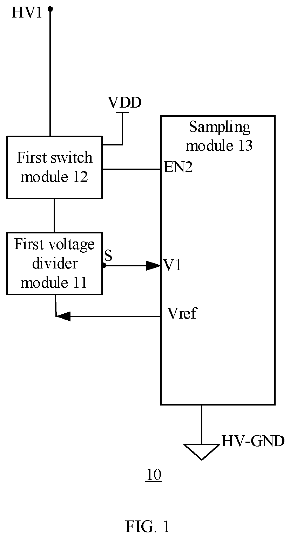

As shown in FIG. 1, the signal sampling circuit 10 according to the embodiments of the present application may include a first voltage divider module 11, a first switch module 12, and a sampling module 13.

The first voltage divider module 11 and the first switch module 12 may be connected in series between a point to be detected HV1 and a reference signal terminal Vref of the sampling module 13. A first control terminal of the first switch module 12 may be connected to a first power supply terminal VDD, a second control terminal of the first switch module 12 may be connected to an enabling signal terminal EN2 of the sampling module 13, and the sampling module 13 may be connected to a first reference ground HV-GND.

Illustratively, the first reference ground HV-GND may be a negative electrode of a battery set to be detected. That is, the first reference ground HV-GND may be a high-voltage ground.

Illustratively, the first reference ground HV-GND may serve as the reference signal terminal Vref, that is, a signal value of the first reference ground HV-GND may be equal to a signal value of the reference signal terminal Vref.

Illustratively, the point to be detected HV1 may be connected to a positive electrode of the battery set to be detected BAT.

Illustratively, the sampling module 13 may include a sampling chip. The sampling chip may be configured to collect a sampled signal of a sampling point S and control the first switch module 12 to be turned on or turned off. The sampling chip may include an analog to digital converter (ADC), and the ADC may be configured to convert a collected sampled signal from an analog signal to a digital signal.

The second control terminal of the first switch module 12 may be connected to the enabling signal terminal EN2 of the sampling module 13, and then the control signal of the enabling signal terminal EN2 may control the voltage of the second terminal of the first switch module 12 and may further control the first switch module 12 to be turned on or turned off. Illustratively, the control signal may include an enabling signal and a disabling signal. The first switch module 12 may be turned on when the enabling signal terminal EN2 outputs the enabling signal, or may be turned off when the enabling signal terminal EN2 outputs the disabling signal. That is, the enabling signal may be a signal that enables the first switch module 12 to be turned on, and the disabling signal may be a signal that enables the first switch module 12 to be turned off. For example, when the first switch module 12 includes a relay and the relay includes a coil and a contact group, the enabling signal may be a low-level signal, and the disabling signal may be a high-level signal.

The first voltage divider module 11 is provided therein with a sampling point S, and the sampling module 13 is configured to collect a sampled signal of the sampling point S.

Illustratively, the sampled signal may be a voltage value of the sampling point S.

Illustratively, the first switch module 12 may include an optical metal-oxide-semiconductor field-effect transistor (MOSFET), an MOS transistor, a relay, and the like.

In the embodiments of the present application, the first control terminal of the first switch module is connected to the first power supply terminal. When the point to be detected is a high-voltage point to be detected, the first power supply terminal may be a high-voltage power supply terminal, and the first reference ground may be a high-voltage ground. The first control terminal of the first switch module is connected to the first power supply terminal, the second control terminal of the first switch module is connected to the enabling signal terminal of the sampling module, and the sampling module is connected to the high-voltage ground. Therefore, the sampling module is on a high voltage side, such that both the control terminal and the controlled terminal of the first switch module are on the high voltage side. Therefore, compared with using a high insulation withstand voltage device, the control terminal and the controlled terminal of the first switch module help reduce costs of the signal sampling circuit.

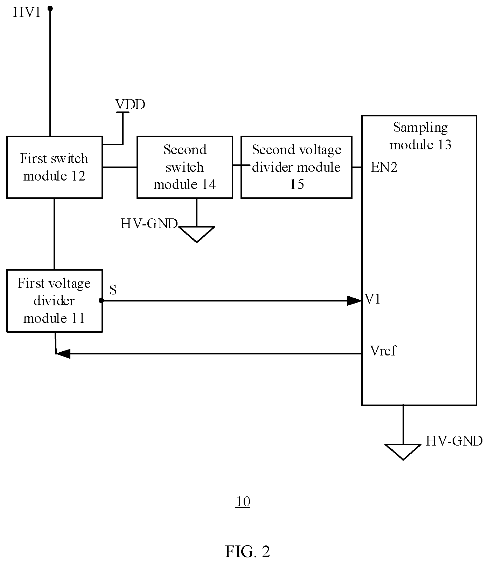

In some optional implementations, as shown in FIG. 2 to FIG. 6, the signal sampling circuit 10 may further include a second switch module 14. The second switch module 14 may be connected between the second control terminal of the first switch module 12 and the first reference ground HV-GND, a control terminal of the second switch module 14 may be connected to the enabling signal terminal EN2, and the second switch module 14 may be configured to be turned on or turned off under the control of a control signal provided by the enabling signal terminal EN2, thereby controlling the first switch module 12 to be turned on or turned off. In this way, when the control signal provided by the enabling signal terminal EN2 cannot drive the first switch module 12 to be turned on or turned off, the control signal provided by the enabling signal terminal EN2 may drive the second switch module 14 to be turned on or turned off, and further control the first switch module 12 to be turned on or turned off, thereby improving the driving capability of the signal sampling circuit 10.

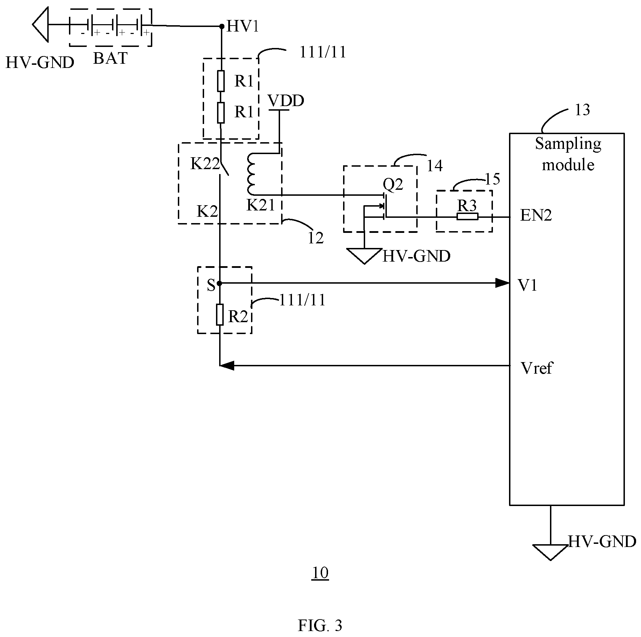

In some optional implementations, as shown in FIG. 3, the first voltage divider module 11 may include a voltage divider submodule 111, and the voltage divider submodule 111 may be provided therein with a sampling point S. The first switch module 12 may include a relay K2, the relay K2 may include a coil K21 and a contact group K22, the voltage divider submodule 111 and the contact group K22 may be connected in series between the point to be detected HV1 and the reference signal terminal Vref of the sampling module 13, a first terminal of the coil K21 may be connected to the first power supply terminal VDD, and a second terminal of the coil K21 may be connected to the enabling signal terminal EN2. In this way, by using the voltage divider submodule 111 with the contact group K22 of the relay K2 to divide the voltage, the voltage of the contact group K22 of the relay K2 is reduced, thereby protecting the relay K2. In addition, the voltage of the second terminal of the coil K21 of the relay K2 is controlled by the enabling signal terminal EN2, and then the contact group K22 of the relay K2 can be controlled to be turned on, and thus the sampling module 13 can collect the sampled signal of the sampling point S.

Optionally, the voltage divider submodule 111 may include a first resistor R1 and a second resistor R2. The first resistor R1 and the second resistor R2 may be connected in series, and the sampling point S may be arranged between the first resistor R1 and the second resistor R2. In this way, by providing the first resistor R1 and the second resistor R2 in the voltage divider submodule 111, the voltage of one or N contact groups of the relay K2 can be reduced, thereby protecting the relay. In addition, the voltage of the second resistor R2 may be flexibly controlled by adjusting the quantity and resistance value of the first resistor R1.

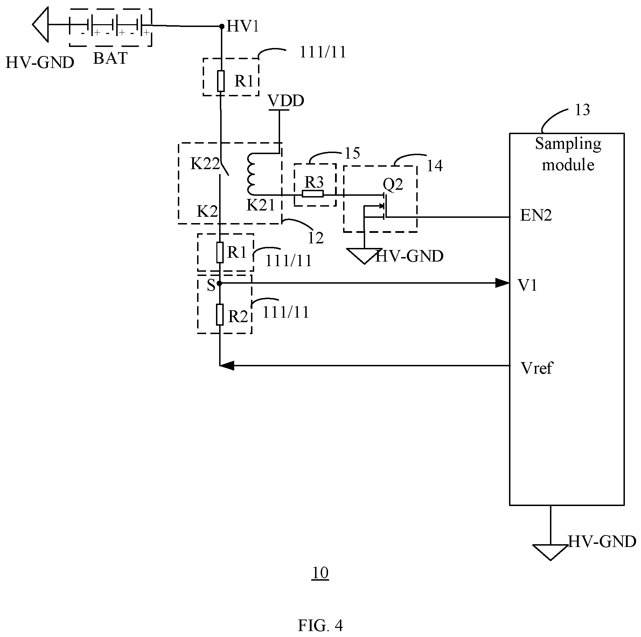

It can be understood that FIG. 4 to FIG. 6 are illustrated by taking the signal sampling circuit 10 including two first resistors R1 as an example. During specific implementation, the quantity of the first resistors R1 may be set according to the actual situation, which is not limited herein. For example, the quantity of the first resistors R1 may be 1, 3, 4, etc. The quantity and resistance value of the first resistors R1 may be determined by the voltage of the point to be detected HV1.

The second resistor R2 may be a sampling resistor.

As an example, as shown in FIG. 3, the first switch module 12 may be connected between the first resistor R1 and the second resistor R2.

As another example, as shown in FIG. 4, the first switch module 12 may be connected between two first resistors R1.

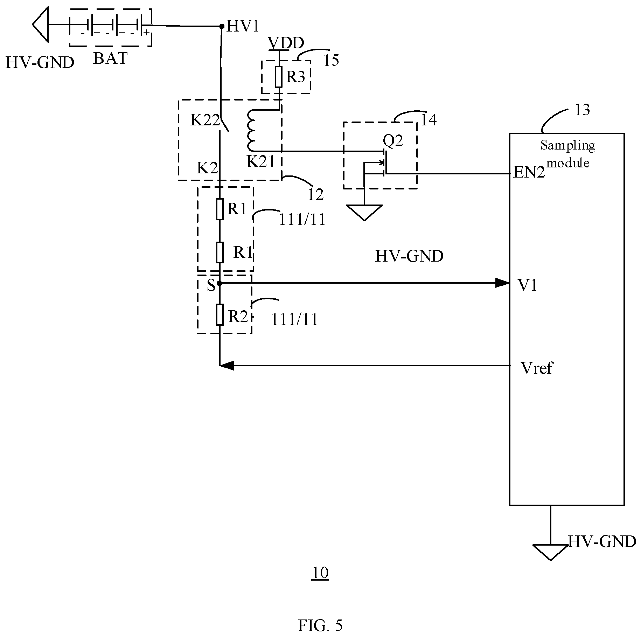

As yet another example, as shown in FIG. 5, the first switch module 12 may be connected between the point to be detected HV1 and the first resistor R1.

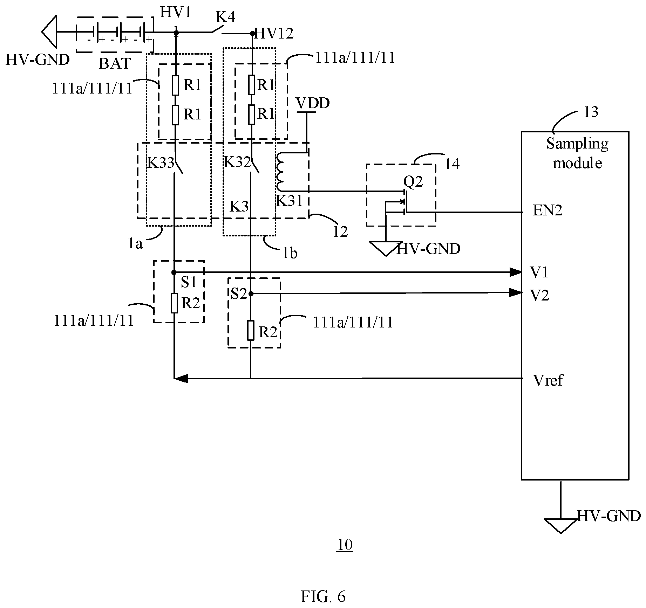

In some other optional implementations, as shown in FIG. 6, the first voltage divider module 11 may include N voltage divider submodules 111, and each voltage divider submodule 111 may be provided therein with a sampling point S, where N may be an integer greater than or equal to 2. The first switch module 12 may include a relay K3, and the relay K3 may include a coil and N contact groups. The voltage divider submodules 111 and the contact groups may be connected in series in one-to-one correspondence to form N branches, one terminal of each of the N branches may be connected to the corresponding point to be detected of the N points to be detected, and the other terminal of each of the N branches may be connected to the reference signal terminal Vref. A first terminal of the coil K31 may be connected to the first power supply terminal VDD, and a second terminal of the coil K31 may be connected to the enabling signal terminal EN2.

In this way, by using the N voltage divider submodules 111 with the N contact groups of the relay K3 to divide the voltages in one-to-one correspondence, the voltages of the N contact groups of the relay K3 are reduced, thereby protecting the relay K3. In addition, the voltage divider submodules 111 and the contact groups are connected in series in one-to-one correspondence to form the N branches, and one terminal of each of the N branches is connected to the corresponding point to be detected of the N points to be detected. Further, the enabling signal terminal EN2 controls the voltage of the second terminal of the coil K31, such that the N contact groups can be controlled to be simultaneously turned on or turned off, and thus the sampling module can simultaneously collect sampled signals of N sampling points that are in one-to-one correspondence to the N points to be detected.

Both the relay K3 and the relay K4 may be small relays such as signal relays.

Illustratively, as shown in FIG. 6, the first voltage divider module 11 may include two voltage divider submodules 111. The voltage divider submodules 111 may be provided with two sampling points, and there are two points to be detected. The relay K3 may include one coil K31 and two contact groups. For ease of description, the two voltage divider submodules 111 are respectively denoted as a first voltage divider submodule 111a and a second voltage divider submodule 111b, the two points to be detected are respectively denoted as a first point to be detected HV11 and a second point to be detected HV12, the two sampling points are respectively denoted as a first sampling point S1 and a second sampling point S2, and the two contact groups are respectively denoted as a first contact group K32 and a second contact group K33. A first branch a1 formed by connecting the first voltage divider submodule 111a and the first contact group K32 in series is connected between the first point to be detected HV11 and the first sampling terminal V1 of the sampling module 13; a second branch b1 formed by connecting the second voltage divider submodule 111b and the second contact group K33 in series is connected between the second point to be detected HV12 and the second sampling terminal V2 of the sampling module 13. There is a switch K4 connected between the first point to be detected HV11 and the second point to be detected HV12, and the first point to be detected HV11 is connected to the positive electrode of the battery set to be detected BAT.

When both the switch K4 and the first switch module 12 are turned on, both the first branch a1 and the second branch a2 are turned on, and the sampling module 13 may collect the first sampled signal of the first sampling point S1 and the second sampled signal of the second sampling point S2. When both the switch K4 and the first switch module 12 are turned off, both the first branch a1 and the second branch a2 are turned off, and the sampling module 13 cannot collect the first sampled signal of the first sampling point S1 and the second sampled signal of the second sampling point S2. When the switch K4 is turned off and the first switch module 12 is turned on, the first branch a1 is turned on, the second branch a2 is turned off, and the sampling module 13 may collect the first sampled signal of the first sampling point S1. When the switch K4 is turned on and the first switch module 12 is turned off, both the first branch a1 and the second branch a2 are turned off, and the sampling module 13 cannot collect the first sampled signal of the first sampling point S1 or the second sampled signal of the second sampling point S2.

The switch K4 may be a relay.

Optionally, the second switch module 14 may include a transistor. In this way, by providing the transistor in the second switch module 14, when the control signal provided by the enabling signal terminal EN2 cannot drive the first switch module 12 to be turned on or turned off, the control signal provided by the enabling signal terminal EN2 may be used to drive the transistor to be turned on or turned off, and further control the first switch module 12 to be turned on or turned off, thereby improving the driving capability of the signal sampling circuit 10.

Optionally, the transistor includes a triode or an MOS transistor. In this way, by providing the triode or the MOS transistor in the second switch module 14, when the control signal provided by the enabling signal terminal EN2 cannot drive the first switch module 12 to be turned on or turned off, the control signal provided by the enabling signal terminal EN2 may be used to drive the triode or the MOS transistor to be turned on or turned off, and further control the first switch module 12 to be turned on or turned off, thereby improving the driving capability of the signal sampling circuit 10.

Illustratively, as shown in FIG. 4 to FIG. 8, the second switch module 14 may include an N-type MOS transistor Q2.

In some optional implementations, as shown in FIG. 3 to FIG. 6, the signal sampling circuit 10 may further include a second voltage divider module 15. The second voltage divider module 15 may be connected between the first power supply terminal VDD and the enabling signal terminal EN2. In this way, by providing the second voltage divider module 15 between the first power supply terminal VDD and the enabling signal terminal EN2, the voltages on the first control terminal and the second control terminal of the first switch module 12 can be reduced, thereby protecting the first switch module 12.

Optionally, the second voltage divider module 15 may include a third resistor R3. In this way, by providing the third resistor R3 in the second voltage divider module 15, the voltages on the first control terminal and the second control terminal of the first switch module 12 can be reduced, thereby protecting the first switch module R3.

As an example, as shown in FIG. 4, the third resistor R3 is connected between an N-type MOS transistor Q2 and the enabling signal terminal EN2.

As another example, as shown in FIG. 5, the third resistor R3 is connected between the relay K21 and the N-type MOS transistor Q2.

As yet another example, as shown in FIG. 6, the third resistor R3 is connected between the relay K21 and the first power supply terminal VDD.

Based on the same inventive concept, the embodiments of the present application further provide a battery management system.

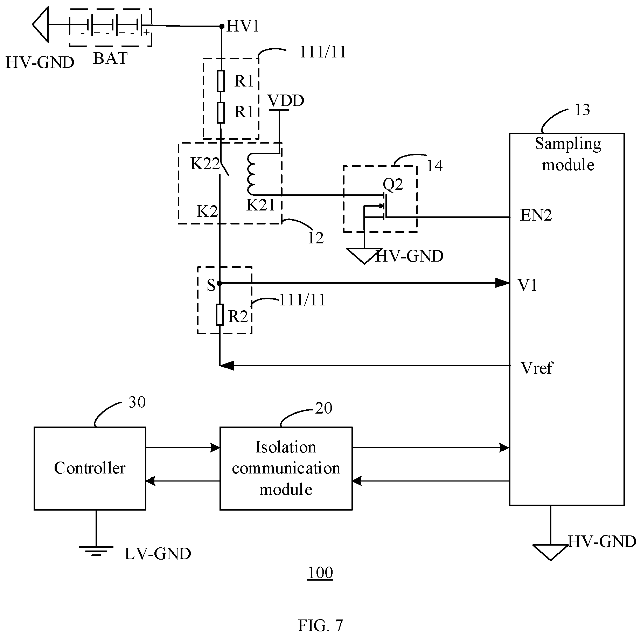

As shown in FIG. 7, the battery management system 100 according to the embodiments of the present application may include:
a controller 30;
an isolation communication module 20; and
the signal sampling circuit 10 in any one of the foregoing embodiments. The sampling module 13 in the signal sampling circuit 10 is connected to the controller 30 by using the isolation communication module 20.

Illustratively, the controller 30 may be configured to:
send a sampling instruction, which is used to instruct the sampling module 13 to collect a sampled signal, to the sampling module 13 via the isolation communication module 20, and transmit the sampled signal to the controller 30 via the isolation communication module 20; and
receive the sampled signal.

In the embodiments of the present application, the controller 30 sends the sampling instruction to the sampling module 13 via the isolation communication module 20 such that the sampling module 13 collects a sampled signal, transmits the sampled signal to the controller 30 via the isolation communication module 20, and receives the sampled signal, which helps the controller 30 to calculate the voltage of the point to be detected HV1 according to the sampled signal.

Illustratively, the controller 30 may include a microcontroller unit (MCU). The isolation communication module 20 may include an isolation communication chip. The isolation communication module 20 may send the sampling instruction to the sampling module 13 via a serial peripheral interface (SPI), an inter-integrated circuit (I2C), a universal asynchronous receiver/transmitter (Uart), a daisy chain, or the like.

Illustratively, the controller 30 may be connected to the second reference ground LV-GND. The second reference ground LV-GND may be the ground. That is, the second reference ground LV-GND may be a low-voltage ground.

Illustratively, taking that there are two first resistors R1 as an example, the voltage U of the point to be detected HV1 may satisfy the formula (1). $U = \left(v1-vref\right) * \left(2r1+r2\right) / r 2$ formula (1)

In the formula, v1 represents the sampled voltage of the sampling point S; vref represents the voltage of the reference signal terminal Vref in the sampling module 13; r1 represents the resistance value of the first resistor R1; and r2 represents the resistance value of the second resistor R2.

It can be understood that values of v1, vref, r1, and r2 are all known, and U may be calculated by substituting the values of v1, vref, r1, and r2 into the formula (1).

It should be noted that, the formula (1) is obtained by taking that there are two first resistors R1 as an example. If the quantity of the first resistors R1 is N, and N is a positive integer, "2r1" in the formula (1) will be "N×r1".

It can be understood that the battery management system has the beneficial effects of the signal sampling circuit according to the embodiments of the present application. For details, reference may be made to the specific description of the signal sampling circuit in the above embodiments, which will not be repeated in this embodiment.

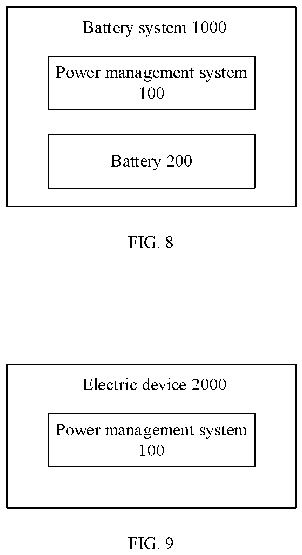

Based on the same inventive concept, as shown in FIG. 8, the embodiments of the present application further provide a battery system. The battery system 1000 may include a battery 200 and a battery management system 100. The battery management system 100 may include the signal sampling circuit in any one of the foregoing embodiments. It can be understood that the battery system has the beneficial effects of the signal sampling circuit according to the embodiments of the present application. For details, reference may be made to the detailed description of the signal sampling circuit in the above embodiments, which will not be repeated in this embodiment.

Based on the same inventive concept, as shown in FIG. 9, the present application further provides an electric device. The electric device 2000 may include a battery management system 100, and the battery management system 100 includes the signal sampling circuit in any one of the foregoing embodiments. It can be understood that the electric device has the beneficial effects of the signal sampling circuit according to the embodiments of the present application. For details, reference may be made to the detailed description of the signal sampling circuit in the above embodiments, which will not be repeated in this embodiment.

It should be noted that, in the embodiments shown in the foregoing figures, the resistor is represented as a single resistor. In other embodiments, the resistor may also be an integration of resistors connected in series, parallel, or series-parallel. Specific parameters of each component may be set according to actual requirements, which is not limited in the present application.

It should be noted that unless conflicting, the embodiments and features of the embodiments in the present application may be combined with each other.

Although the present application has been described with reference to preferred embodiments, various modifications may be made and components herein may be replaced with equivalents without departing from the scope of the present application. In particular, the technical features mentioned in the embodiments may be combined in any manner as long as there are no structural conflicts. The present application is not limited to the specific embodiments disclosed herein, but encompasses all technical solutions falling within the scope of the claims.

## Claims

1. A signal sampling circuit, comprising a first voltage divider module, a first switch module, and a sampling module, wherein
the first voltage divider module and the first switch module are connected in series between a point to be detected and a reference signal terminal of the sampling module, a first control terminal of the first switch module is connected to a first power supply terminal, a second control terminal of the first switch module is connected to an enabling signal terminal of the sampling module, and the sampling module is connected to a first reference ground;
the first voltage divider module is provided therein with a sampling point, and the sampling module is configured to collect a sampled signal of the sampling point.

2. The signal sampling circuit according to claim 1, wherein the signal sampling circuit further comprises a second switch module, the second switch module is connected between the second control terminal of the first switch module and the first reference ground, a control terminal of the second switch module is connected to the enabling signal terminal, and the second switch module is configured to be turned on or turned off under control of a control signal provided by the enabling signal terminal and further control the first switch module to be turned on or turned off.

3. The signal sampling circuit according to claim 1, wherein the signal sampling circuit further comprises a second voltage divider module, and the second voltage divider module is connected between the first power supply terminal and the enabling signal terminal.

4. The signal sampling circuit according to claim 1, wherein the first voltage divider module comprises a voltage divider submodule, and the voltage divider submodule is provided therein with a sampling point;
the first switch module comprises a relay, the relay comprises a coil and a contact group, the voltage divider submodule and the contact group are connected in series between the point to be detected and the reference signal terminal of the sampling module, a first terminal of the coil is connected to the first power supply terminal, and a second terminal of the coil is connected to the enabling signal terminal.

5. The signal sampling circuit according to claim 1, wherein the first voltage divider module comprises N voltage divider submodules, and each of the voltage divider submodules is provided therein with a sampling point, wherein N is an integer greater than or equal to 2;
the first switch module comprises a relay, the relay comprises a coil and N contact groups, the voltage divider submodules and the contact groups are connected in series in one-to-one correspondence to form N branches, one terminal of each of the N branches is connected to the corresponding point to be detected of the N points to be detected, the other terminal of each of the N branches is connected to the reference signal terminal, a first terminal of the coil is connected to the first power supply terminal, and a second terminal of the coil is connected to the enabling signal terminal.

6. The signal sampling circuit according to claim 2, wherein the second switch module comprises a transistor.

7. The signal sampling circuit according to claim 6, wherein the transistor comprises a triode or an MOS transistor.

8. The signal sampling circuit according to claim 4 or 5, wherein the voltage divider submodule comprises a first resistor and a second resistor, the first resistor and the second resistor are connected in series, and the sampling point is arranged between the first resistor and the second resistor.

9. The signal sampling circuit according to claim 3, wherein the second voltage divider module comprises a third resistor.

10. A battery management system, comprising:
a controller;
an isolation communication module; and
the signal sampling circuit according to any one of claims 1 to 9, wherein the sampling module in the signal sampling circuit is connected to the controller via the isolation communication module.

11. A battery system, comprising a battery and the battery management system according to claim 10.

12. An electric device, comprising the battery management system according to claim 10.
